# FASCICULE DE BREVET EUROPEEN

(11) **EP 3 590 708 B1**
(45) Date de publication et mention de la délivrance du brevet: **26.03.2025**
(21) Numéro de dépôt: 19188149.9
(22) Date de dépôt: 10.10.2013
(51) Int. Cl.: B32B 17/10, B60J 1/00

(54) **VITRAGE FEUILLETE**
MEHRSCHICHTENGLAS
LAMINATED GLAZING

(30) Priorité: 12.10.2012 FR 1259728
(43) Date de publication de la demande: 08.01.2020
(62) Demande divisionnaire de: 13786698.4
(73) Titulaire: SAINT-GOBAIN GLASS FRANCE, 92400 Courbevoie (FR)
(72) Inventeur: BURELOUX, Dominique, 02300 OGNES (FR); GIROD, Adeline, 75010 PARIS (FR); HENNION, Alexandre, 60280 VENETTE (FR); SCHLARB, Andreas, 52134 HERZOGENRATH (DE); STELLING, Bernd, 52134 HERZOGENRATH (DE)
(74) Mandataire: Saint-Gobain Recherche

(56) Documents cités:
- EP-A2- 1 710 104
- FR-A1- 2 996 802
- FR-A1- 2 996 803
- FR-A2- 2 348 616
- GB-A- 1 329 790

## Description

L'invention concerne un vitrage feuilleté destiné à amener des fils conducteurs jusqu'à un accessoire tel que par exemple une caméra ou un capteur de pluie.

Il est connu de disposer des accessoires électriques tels qu'une caméra ou un capteur de pluie sur un pare-brise de véhicule automobile à proximité du rétroviseur. Un pare-brise est habituellement constitué de deux feuilles de verre entre lesquelles est disposé un intercalaire en polymère thermoplastique. On numérote les surfaces des feuilles de verre d'un tel vitrage feuilleté de 1 à 4 en partant de la surface externe du vitrage destinée à être tournée vers l'extérieur du véhicule et en finissant par la surface externe du vitrage destinée à être tournée vers l'intérieur du véhicule.

L'alimentation électrique des accessoires électriques, constituée de fils conducteurs, est en général fixée sur la face 4 du pare-brise. Les fils conducteurs sont cachés à la vue à l'intérieur de l'habitacle par une goulotte fixée sur le vitrage, la goulotte recouvrant les fils conducteurs. Les fils conducteurs sont cachés à la vue à l'extérieur de l'habitacle par une bande d'émail noir déposée par exemple en face 2 ou en face 4 du pare-brise.

Toutefois, il arrive souvent que les fils ne soient pas bien positionnés dans la goulotte ou dépassent de la bande d'émail. De plus, la goulotte prend de la place sur le pare-brise et cache une partie de la vue au conducteur, en particulier sur des pare-brise panoramiques. De plus, la goulotte peut être source de bruit à certaines vitesses du fait des vibrations du pare-brise.

FR 2 348 616 A2 décrit un vitrage feuilleté comprenant une première et une deuxième feuille de verre, la première feuille de verre étant munie d'un premier trou traversant, un film intercalaire en matière thermoplastique disposé entre les première et deuxième feuilles de verre, et un fil conducteur noyé dans le film intercalaire, une extrémité du fil conducteur sortant du vitrage feuilleté par le premier trou traversant de la première feuille de verre.

Il y a donc un besoin pour un vitrage feuilleté permettant l'amenée de fils conducteurs, qui garantisse une qualité de positionnement des fils conducteurs, qui permette d'avoir un champ de vision le plus grand possible et qui pallie au problème de bruit de la goulotte.

Pour cela, l'invention propose un vitrage feuilleté destiné à être monté sur un véhicule automobile, comprenant:
- une première et une deuxième feuilles de verre, la première feuille de verre étant munie d'un premier trou traversant,
- un film intercalaire en polymère thermoplastique disposé entre les première et deuxième feuilles de verre,
- au moins un fil conducteur noyé dans le film intercalaire ou disposé entre le film intercalaire et la première feuille de verre ou disposé entre le film intercalaire et la deuxième feuille de verre, une extrémité de chaque fil conducteur sortant du vitrage feuilleté par le premier trou traversant de la première feuille de verre, et dans lequel le ou les fils conducteurs sont enrobés dans un film plastique formant une nappe, le film plastique formant la nappe pouvant notamment être transparent ou noir ou de couleur, la nappe étant équipée de connecteurs à chacune de ses extrémités.

Selon une autre particularité, lorsque le fil conducteur est disposé entre le film intercalaire et la deuxième feuille de verre, le film intercalaire est muni d'un trou traversant permettant le passage du fil conducteur à travers le film intercalaire et à travers la première feuille de verre, le trou traversant du film intercalaire ayant une taille comprise entre une valeur minimale permettant juste le passage du fil conducteur et une valeur maximale pour laquelle le trou coïncide sensiblement avec le premier trou de la première feuille de verre.

Selon une autre particularité, la deuxième feuille de verre est également munie d'un trou traversant, le premier trou traversant de la première feuille de verre et le trou traversant de la deuxième feuille de verre ayant sensiblement la même taille et se faisant face, et le film intercalaire est également muni d'un trou traversant coïncidant avec les trous traversants des première et deuxième feuilles de verre.

Selon une autre particularité, l'autre extrémité de chaque fil conducteur sort du vitrage feuilleté par la tranche du vitrage feuilleté ou par un deuxième trou traversant de la première feuille de verre situé en bord de vitrage ou par un trou traversant de la deuxième feuille de verre situé en bord de vitrage.

Selon une autre particularité, la première feuille de verre est munie de plusieurs premiers trous traversants disposés à proximité les uns des autres.

Selon une autre particularité, le vitrage feuilleté comprend plusieurs fils conducteurs, une extrémité de chaque fil conducteur sortant du vitrage feuilleté par le ou les premiers trous traversants de la première feuille de verre.

Selon une autre particularité, chaque trou traversant a une taille comprise entre 3 et 80 mm.

Selon une autre particularité, le vitrage feuilleté comprend en outre au moins une bande d'émail opaque coïncidant avec le ou les fils conducteurs, cachant à la vue le ou les fils conducteurs depuis l'extérieur et/ou l'intérieur.

Selon une autre particularité, le vitrage feuilleté comprend en outre un accessoire fixé sur le vitrage feuilleté à proximité ou au niveau du ou des premiers trous traversants, l'accessoire étant connecté à l'extrémité du ou des fils conducteurs sortant du vitrage feuilleté par le ou les premiers trous traversants de la première feuille de verre.

Selon une autre particularité, l'accessoire est un capteur de pluie ou d'humidité, un capteur de luminosité, une caméra, une antenne, un dispositif d'éclairage, un ventilateur ou encore un dispositif de positionnement par GPS.

Selon une autre particularité, l'accessoire peut être fixé sur les ou à proximité des bords du ou des premiers trous traversants de la première feuille de verre ou logé à l'intérieur d'un trou traversant de la première feuille de verre et fixé sur la deuxième feuille de verre.

Selon une autre particularité, le fil conducteur est un câble coaxial, de préférence blindé.

L'invention concerne également un procédé de fabrication d'un vitrage feuilleté comprenant :
- la fourniture d'une première et d'une deuxième feuilles de verre,
- la découpe d'un premier trou traversant dans la première feuille de verre,
- si nécessaire, le bombage des première et deuxième feuilles de verre,
- la fourniture d'un ou plusieurs fils conducteurs et d'un film en polymère thermoplastique éventuellement muni d'un trou traversant, et la fixation du ou des fils conducteurs sur le film en polymère thermoplastique,
- la mise en place du film en polymère thermoplastique portant le ou les fils conducteurs entre les première et deuxième feuilles de verre, et la sortie d'une extrémité du ou des fils conducteurs par le premier trou traversant, ladite extrémité étant équipée d'un connecteur avant passage à travers le premier trou traversant,
- le dégazage sous vide de l'ensemble, avec utilisation d'un joint périphérique ou d'un sac à vide ainsi que d'un adhésif pour boucher le ou les trous traversants de la ou des feuilles de verre ou d'une ventouse aspirante pour aspirer l'air par le ou les trous traversants de la ou des feuilles de verre,
- le scellage à chaud des bords du vitrage feuilleté et des bords du ou des trous traversants,
- l'autoclavage de l'ensemble.

L'invention concerne également un procédé de fabrication d'un vitrage feuilleté comprenant :
- la fourniture d'une première et d'une deuxième feuilles de verre,
- la découpe d'un premier trou traversant dans la première feuille de verre,
- si nécessaire, le bombage des première et deuxième feuilles de verre,
- la fourniture d'un ou plusieurs fils conducteurs enrobés dans un film plastique transparent formant une nappe, et d'un film en polymère thermoplastique éventuellement muni d'un trou traversant,
- la mise en place du film en polymère thermoplastique entre les première et deuxième feuilles de verre, la nappe de fils conducteurs étant disposée entre le film en polymère thermoplastique et la première feuille de verre ou la deuxième feuille de verre, et la sortie d'une extrémité du ou des fils conducteurs par le premier trou traversant, la nappe étant équipée de connecteurs à chacune de ses extrémités avant assemblage du vitrage,
- le dégazage sous vide de l'ensemble, avec utilisation d'un joint périphérique ou d'un sac à vide ainsi que d'un adhésif pour boucher le ou les trous traversants de la ou des feuilles de verre ou d'une ventouse aspirante pour aspirer l'air par le ou les trous traversants de la ou des feuilles de verre,
- le scellage à chaud des bords du vitrage feuilleté et des bords du ou des trous traversants,
- l'autoclavage de l'ensemble.

D'autres caractéristiques et avantages de l'invention vont à présent être décrits en regard des dessins sur lesquels :
- La figure 1 représente une vue en coupe d'un vitrage feuilleté selon l'invention ;
- Les figures 2a, 2b, 2c sont une vue de détail, selon trois modes de réalisation respectifs, du vitrage feuilleté selon l'invention avec plusieurs fils conducteurs ;
- La figure 3 est une vue de détail du bord du vitrage feuilleté selon un mode de réalisation de l'invention ;
- Les figures 4 et 5 sont des vues en coupe, selon deux modes de réalisation respectifs, d'un vitrage feuilleté selon l'invention avec un accessoire d'antenne monté sur le vitrage.

Les numéros de référence qui sont identiques sur les différentes figures représentent des éléments similaires ou identiques.

Dans l'ensemble de la description, le terme « fil » ne doit pas être compris comme limitatif. En effet, il couvre également les câbles.

Dans l'ensemble de la description, la « taille » d'un trou signifie la plus grande dimension du trou, à savoir le diamètre lorsque le trou est circulaire.

L'invention se rapporte à un vitrage feuilleté comprenant une première et une deuxième feuilles de verre, ainsi qu'un film intercalaire en polymère thermoplastique disposé entre les deux feuilles de verre. La première feuille de verre est munie d'un premier trou traversant. Le vitrage feuilleté comprend également au moins un fil conducteur noyé dans le film intercalaire ou disposé entre le film intercalaire et la première feuille de verre ou disposé entre le film intercalaire et la deuxième feuille de verre, une extrémité du fil conducteur sortant du vitrage feuilleté par le premier trou traversant de la première feuille de verre.

Ainsi, le ou les fils conducteurs sont disposés entre les deux feuilles de verre en étant noyés dans le film en polymère thermoplastique ou en étant disposés entre le film en polymère thermoplastique et une des feuilles de verre, ce qui garantit une qualité de positionnement des fils conducteurs et une plus grande facilité de transport sans abîmer les fils conducteurs. De plus, la goulotte n'est plus nécessaire car les fils conducteurs peuvent sortir du vitrage à l'endroit même du positionnement de l'accessoire à connecter. De ce fait, le champ de vision est amélioré et il n'y a plus de bruit engendré par la goulotte pendant la marche du véhicule.

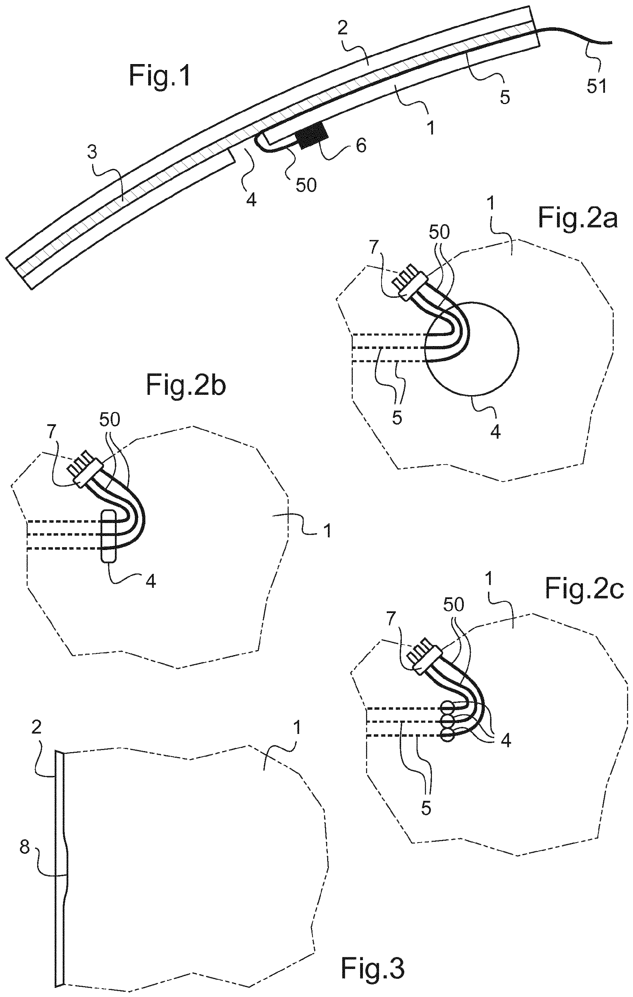

La figure 1 représente une vue en coupe d'un vitrage feuilleté selon l'invention.

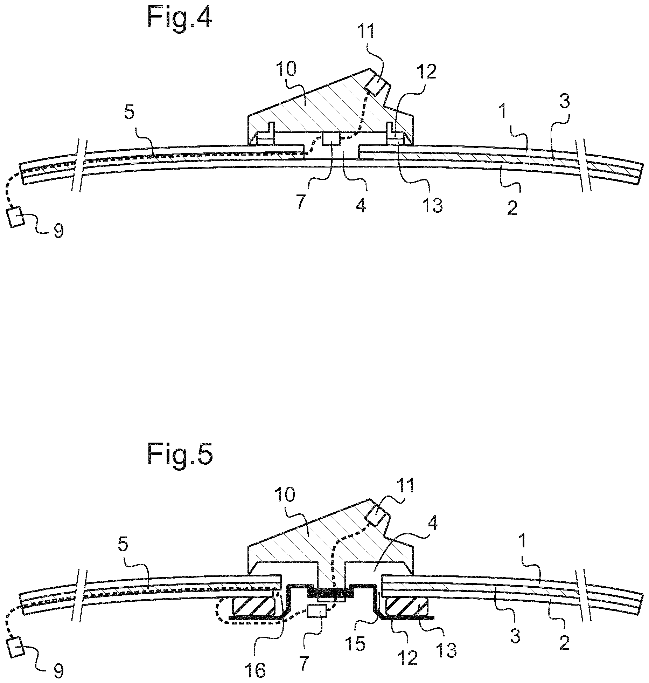

Le vitrage feuilleté comprend une première feuille de verre 1, une deuxième feuille de verre 2 et un film intercalaire 3 en polymère thermoplastique, disposé entre les deux feuilles de verre. Le film intercalaire est par exemple un film de PVB, standard ou avec des propriétés d'amortissement acoustique. La première feuille de verre comprend un premier trou traversant 4. La première feuille de verre 1 peut aussi bien être positionnée du côté interne que du côté externe du véhicule, selon les applications. De plus, le film intercalaire peut comprendre un trou traversant coïncidant avec le premier trou traversant 4 de la première feuille de verre, comme représenté sur la figure 4.

Le vitrage feuilleté comprend également au moins un fil conducteur 5 qui est noyé dans le film intercalaire 3 ou qui est disposé entre le film intercalaire 3 et la première feuille de verre 1, ou encore qui est disposé entre le film intercalaire 3 et la deuxième feuille de verre 2. Cela lui procure une protection qui est intégrée au vitrage feuilleté. Lorsque le fil conducteur 5 est disposé entre le film intercalaire 3 et la deuxième feuille de verre 2, le film intercalaire 3 peut être muni d'un trou traversant qui coïncide avec le premier trou 4 de la première feuille de verre 1, c'est-à-dire qui a sensiblement la même taille et qui est en vis-à-vis, pour permettre le passage du fil conducteur 5 à travers le film intercalaire 3 et à travers la première feuille de verre 1. Toutefois, de préférence, lorsque le fil conducteur 5 est disposé entre le film intercalaire 3 et la deuxième feuille de verre 2, le film intercalaire 3 est percé d'un trou traversant qui est le plus petit possible pour assurer juste le passage du fil conducteur 5. Le trou traversant dans le film intercalaire 3 peut également avoir toutes les tailles possibles entre ces deux valeurs extrêmes. La taille maximale du trou traversant du film intercalaire est au plus de 10 mm plus importante que la taille du trou traversant de la feuille de verre. De façon préférée, lorsqu'aucun fil conducteur n'est amené à traverser le film intercalaire, le film intercalaire ne comporte aucun trou traversant, ce qui permet au vitrage de mieux résister aux chocs.

Le fil conducteur 5 a une extrémité 50 qui est destinée à être connectée à un accessoire 6, par exemple un accessoire électrique, via un connecteur (7 sur les figures 2, 4 et 5). L'autre extrémité 51 du fil conducteur 5 est destinée à être connectée à une alimentation électrique et/ou un dispositif électrique sur le véhicule, via un connecteur (9 sur les figures 4 et 5). Une extrémité 50 du fil conducteur 5 sort du vitrage feuilleté par le premier trou traversant 4. Le premier trou traversant 4 est par exemple circulaire, pour une facilité de fabrication. Il doit être le petit possible pour permettre au vitrage feuilleté de respecter la norme R43 et suffisamment grand pour permettre le passage du fil conducteur et du connecteur, à travers. Ainsi, de préférence, le premier trou traversant 4 a une taille comprise entre 3 et 80 mm.

Le connecteur 7, 9 permet de protéger l'extrémité du fil conducteur 5 lors du transport et de la manutention. Le connecteur 7, 9 est de préférence le plus compact possible tout en étant stable mécaniquement et en étant capable d'assurer une connexion électrique fiable dans un environnement véhicule, en particulier en résistant aux diverses agressions potentielles telles que vibrations, variations de températures importantes, atmosphère oxydante, etc.

Dans un mode de réalisation du procédé de fabrication d'un vitrage feuilleté, le ou les fils conducteurs 5 sont enrobés dans un film plas-10 tique formant une nappe mince et souple. Dans le vitrage feuilleté selon l'invention, le ou les fils conducteurs 5 sont enrobés dans un film plastique formant une nappe. Le film plastique peut être transparent (ce qui permet d'avoir un produit très discret), noir (ce qui évite d'ajouter de l'émail noir sur le verre pour masquer les fils conducteurs), ou encore de couleur (ce qui peut permettre d'améliorer l'aspect du produit fini, une fois intégré dans un vitrage). L'utilisation d'une telle nappe procure de plus une facilité de manutention lors de l'assemblage. La nappe est équipée de connecteurs à chacune de ses extrémités avant assemblage du vitrage. De plus, afin de faciliter le montage, la nappe peut être enduite de PVB ou d'un adhésif pour permettre son adhésion à la première feuille de verre. Enfin, la nappe doit de plus être suffisamment fine pour ne pas mettre en flexion permanente le verre lors de l'assemblage et pour ainsi éviter toute casse du verre au niveau du bord du ou des trous par lesquels sort la nappe. Pour pallier à cela, le verre a de préférence des contraintes de bord en périphérie des trous de sortie des extrémités des fils conducteurs.

L'accessoire 6 auquel est destiné à être connecté le ou les fils conducteurs 5 peut être fixé sur le vitrage feuilleté, comme représenté sur la figure 1, ou à proximité du vitrage feuilleté, par exemple sur un support de rétroviseur. L'accessoire 6 est par exemple un capteur de pluie ou d'humidité, un capteur de luminosité, une caméra, une antenne, un dispositif d'éclairage, un ventilateur ou encore un dispositif de positionnement par GPS. Le fil conducteur 5 permet l'alimentation électrique de l'accessoire 6 et/ou l'amenée d'informations émises par l'accessoire 6 vers le dispositif électrique du véhicule. Le fil conducteur 5 est par exemple en cuivre. En fonction des applications, par exemple pour la connexion à une caméra, le ou les fils conducteurs 5 peuvent être des câbles coaxiaux, de préférence blindés.

En fonction du type d'accessoire, un ou plusieurs fils conducteurs 5 sont nécessaires.

Les figures 2a, 2b, 2c sont une vue de détail, selon trois modes de réalisation respectifs, du vitrage feuilleté selon l'invention avec plusieurs fils conducteurs.

Sur la figure 2a, la première feuille de verre 1 comporte un unique premier trou traversant 4, de forme circulaire, par lequel sortent les extrémités 50 des fils conducteurs 5 destinées à être connectées à un accessoire.

Sur la figure 2b, la première feuille de verre 1 comporte un unique premier trou traversant 4, en forme de fente, par lequel sortent les extrémités 50 des fils conducteurs 5 destinées à être connectées à un accessoire.

Sur la figure 2c, la première feuille de verre 1 comporte trois premiers trous traversants 4, de forme circulaire, par chacun desquels sort l'extrémité 50 d'un fil conducteur 5 destinée à être connectée à un accessoire.

Les trous traversants circulaires peuvent être réalisés par une scie cloche. Les trous traversants en forme de fente peuvent être réalisés par perçage au jet d'eau ou par usinage par une fraise diamantée.

L'extrémité 50 du ou des fils conducteurs 5 destinée à être connectée à l'accessoire 6 peut être insérée dans un connecteur 7, comme représenté sur les figures 2a à 2c, ce qui facilite la connexion à l'accessoire 6, en particulier lorsque celle-ci a lieu bien après la fabrication du vitrage feuilleté.

La figure 3 est une vue de détail du bord du vitrage feuilleté selon un mode de réalisation de l'invention.

La première feuille de verre 1 peut comprendre un deuxième trou traversant 8 en bord de vitrage. Le deuxième trou traversant 8 permet la sortie de l'autre extrémité 51 du fil conducteur 5 pour une connexion à une alimentation électrique et/ou un dispositif électrique sur le véhicule. Cette autre extrémité 51 peut être insérée dans un connecteur 9 (figures 4 et 5) pour une facilité de connexion ultérieure au véhicule. Le deuxième trou traversant 8 de la première feuille de verre 1 peut être réalisé sur le bord de la première feuille de verre 1, par exemple en forme d'encoche, comme représenté sur la figure 3, ou à proximité du bord de la première feuille de verre 1.

Lorsque la première feuille de verre 1 ne comprend pas de deuxième trou traversant 8, l'extrémité 51 du fil conducteur 5 sort du vitrage feuilleté par la tranche du vitrage feuilleté, comme représenté sur la figure 1.

De façon optionnelle, le vitrage feuilleté comprend en outre au moins une bande d'émail opaque coïncidant avec le ou les fils conducteurs, cachant à la vue le ou les fils conducteurs depuis l'extérieur et/ou l'intérieur du véhicule. Toutefois, les fils conducteurs noyés dans le film intercalaire pouvant être très fins (quelques dizaines à quelques centaines de microns) et la nappe ayant une largeur fine (quelques millimètres à une quinzaine de millimètres), la bande d'émail est bien plus fine que lorsqu'une goulotte est utilisée, et la bande d'émail n'est pas tridimensionnelle comme la goulotte, ce qui permet d'améliorer nettement le champ de vision et le confort visuel.

Le vitrage feuilleté peut également comprendre un accessoire 6 fixé sur le vitrage feuilleté. L'accessoire 6 peut être fixé sur les bords du ou des premiers trous traversants 4 de la première feuille de verre 1, par exemple par encliquetage ou par collage, ou à proximité du ou des premiers trous traversants 4 de la première feuille de verre 1, par exemple par collage. En variante, l'accessoire peut également être logé à l'intérieur du trou traversant 4 de la première feuille de verre 1 et être fixé, par exemple par collage, sur la deuxième feuille de verre 2, en face 2 ou 3 du vitrage feuilleté suivant le positionnement des première et deuxième feuilles de verre dans le vitrage feuilleté.

Par ailleurs, la deuxième feuille de verre peut également comprendre un trou traversant (15, figure 5). Dans ce dernier cas, le premier trou traversant 4 de la première feuille de verre 1 et le trou traversant 15 de la deuxième feuille de verre 2 ont de préférence sensiblement la même taille et se font face. Le film intercalaire est alors également muni d'un trou traversant qui coïncide avec les premiers trous 4, 15 des première et deuxième feuilles de verre 1, 2, comme représenté sur la figure 5, c'est-à-dire qui a sensiblement la même taille et qui est en vis-à-vis des trous traversants 4 et 15. La taille maximale du trou traversant du film intercalaire est au plus de 10 mm plus importante que la taille des trous traversants des deux feuilles de verre.

La deuxième feuille de verre 2 peut également comprendre un trou traversant en bord de vitrage, qui peut être réalisé sur le bord de la deuxième feuille de verre 2, par exemple en forme d'encoche, ou à proximité du bord de la deuxième feuille de verre 2.

Les figures 4 et 5 sont des vues en coupe, selon deux modes de réalisation respectifs, d'un vitrage feuilleté selon l'invention avec un accessoire d'antenne monté sur le vitrage.

Ces figures sont des exemples de réalisation d'un vitrage feuilleté comprenant une antenne.

Un socle d'antenne 10 est fixé sur le vitrage feuilleté par des moyens de fixation 13, par exemple de la colle, via des moyens de support 12. Le socle d'antenne 10 comprend un connecteur 11 auquel est connecté le fil conducteur 5 via le connecteur 7.

Dans ces modes de réalisation, la première feuille de verre 1 est tournée vers l'extérieur du véhicule. L'étanchéité à l'eau est assurée par les moyens de fixation 13 qui entourent entièrement les trous traversants.

Dans le mode de réalisation de la figure 5, la deuxième feuille de verre comprend également un trou traversant 15. Sur la figure 5, le trou traversant 15 coïncide avec le premier trou traversant 4 et comporte en plus une encoche 16 pour faciliter le passage du fil conducteur 5.

## Revendications

1. **Procédé** de fabrication d'un vitrage feuilleté comprenant :
- une première et une deuxième feuilles de verre (1, 2), la première feuille de verre (1) étant munie d'un premier trou traversant (4),
- un film intercalaire (3) en polymère thermoplastique disposé entre les première et deuxième feuilles de verre (1,2),
- au moins un fil conducteur (5) noyé dans le film intercalaire (3) ou disposé entre le film intercalaire (3) et la première feuille de verre (1) ou disposé entre le film intercalaire et la deuxième feuille de verre, une extrémité (50) de chaque fil conducteur (5) sortant du vitrage feuilleté par le premier trou traversant (4) de la première feuille de verre (1),
ledit procédé comprenant :
- la fourniture de la première et de la deuxième feuilles de verre (1, 2),
- la découpe d'un premier trou traversant (4) dans la première feuille de verre (1),
- si nécessaire, le bombage des première et deuxième feuilles de verre (1, 2),
- soit
o la fourniture du ou des fils conducteurs (5) et du film (3) en polymère thermoplastique éventuellement muni d'un trou traversant, et la fixation du ou des fils conducteurs (5) sur le film (3) en polymère thermoplastique, la mise en place du film (3) en polymère thermoplastique portant le ou les fils conducteurs (5) entre les première et deuxième feuilles de verre (1, 2), et la sortie d'une extrémité (50) du ou des fils conducteurs (5) par le premier trou traversant (4), ladite extrémité (50) étant équipée d'un connecteur avant passage à travers le premier trou traversant,
soit
o la fourniture du ou des fils conducteurs (5) enrobés dans un film plastique formant une nappe, et d'un film (3) en polymère thermoplastique éventuellement muni d'un trou traversant, puis la mise en place du film (3) en polymère thermoplastique entre les première et deuxième feuilles de verre (1, 2), la nappe de fils conducteurs étant disposée entre le film (3) en polymère thermoplastique et la première feuille de verre (1) ou la deuxième feuille de verre (2), et la sortie d'une extrémité (50) du ou des fils conducteurs (5) par le premier trou traversant (4), la nappe étant équipée de connecteurs à chacune de ses extrémités avant assemblage du vitrage,
- le dégazage sous vide de l'ensemble, avec utilisation d'un joint périphérique ou d'un sac à vide ainsi que d'un adhésif pour boucher le ou les trous traversants de la ou des feuilles de verre ou d'une ventouse aspirante pour aspirer l'air par le ou les trous traversants de la ou des feuilles de verre,
- le scellage à chaud des bords du vitrage feuilleté et des bords du ou des trous traversants,
- l'autoclavage de l'ensemble.

2. Procédé selon la revendication précédente, **caractérisé en ce que** lorsque le fil conducteur (5) est disposé entre le film intercalaire (3) et la deuxième feuille de verre (2), le film intercalaire (3) est muni d'un trou traversant permettant le passage du fil conducteur (5) à travers le film intercalaire (3) et à travers la première feuille de verre (1), le trou traversant du film intercalaire ayant une taille comprise entre une valeur minimale permettant juste le passage du fil conducteur et une valeur maximale pour laquelle le trou coïncide sensiblement avec le premier trou (4) de la première feuille de verre (1).

3. Procédé selon l'une des revendications précédentes, **caractérisé en ce que** la deuxième feuille de verre (2) est également munie d'un trou traversant (15), le premier trou traversant (4) de la première feuille de verre (1) et le trou traversant (15) de la deuxième feuille de verre (2) ayant sensiblement la même taille et se faisant face, le film intercalaire (3) étant également muni d'un trou traversant coïncidant avec les trous traversants (4, 15) des première et deuxième feuilles de verre (1, 2).

4. Procédé selon l'une des revendications précédentes, **caractérisé en ce que** le ou les fils conducteurs (5) sont enrobés dans un film plastique formant une nappe, le film plastique formant la nappe étant transparent ou noir ou de couleur.

5. Procédé selon l'une des revendications précédentes, **caractérisé en ce que** l'autre extrémité (51) de chaque fil conducteur (5) sort du vitrage feuilleté par la tranche du vitrage feuilleté ou par un deuxième trou traversant (8) de la première feuille de verre (1) situé en bord de vitrage ou par un trou traversant de la deuxième feuille de verre (2) situé en bord de vitrage, chaque fil conducteur étant d'un seul tenant entre les deux sorties du vitrage feuilleté.

6. Procédé selon l'une des revendications précédentes, **caractérisé en ce que** le vitrage comprend plusieurs fils conducteurs (5), une extrémité (50) de chaque fil conducteur (5) sortant du vitrage feuilleté par le ou les premiers trous traversants (4) de la première feuille de verre (1).

7. Procédé selon l'une des revendications précédentes, **caractérisé en ce que** chaque trou traversant (4, 8, 15) a une taille comprise entre 3 et 80 mm.

8. Procédé selon l'une des revendications précédentes, **caractérisé en ce que** au moins une bande d'émail opaque coïncide avec le ou les fils conducteurs (5), cachant à la vue le ou les fils conducteurs depuis l'extérieur et/ou l'intérieur.

9. Procédé selon l'une des revendications précédentes, **caractérisé en ce que** le fil conducteur (5) est un câble coaxial, de préférence blindé.

10. Procédé selon l'une des revendications précédentes, **caractérisé en ce qu'**un accessoire (6), notamment un capteur de pluie ou d'humidité, un capteur de luminosité, une caméra, une antenne, un dispositif d'éclairage, un ventilateur ou encore un dispositif de positionnement par GPS, est fixé sur le vitrage feuilleté à proximité ou au niveau du ou des premiers trous traversants (4), l'accessoire étant connecté à l'extrémité (50) du ou des fils conducteurs (5) sortant du vitrage feuilleté par le ou les premiers trous traversants (4) de la première feuille de verre (1).

11. Procédé selon la revendication précédente, **caractérisé en ce que** l'accessoire (6) est fixé sur les ou à proximité des bords du ou des premiers trous traversants (4) de la première feuille de verre (1) ou logé à l'intérieur d'un trou traversant (4) de la première feuille de verre (1) et fixé sur la deuxième feuille de verre (2).

12. Vitrage feuilleté destiné à être monté sur un véhicule automobile, comprenant :
- une première et une deuxième feuilles de verre (1, 2), la première feuille de verre (1) étant munie d'un premier trou traversant (4),
- un film intercalaire (3) en polymère thermoplastique disposé entre les première et deuxième feuilles de verre (1,2),
- au moins un fil conducteur (5) noyé dans le film intercalaire (3) ou disposé entre le film intercalaire (3) et la première feuille de verre (1) ou disposé entre le film intercalaire et la deuxième feuille de verre, une extrémité (50) de chaque fil conducteur (5) sortant du vitrage feuilleté par le premier trou traversant (4) de la première feuille de verre (1),
et dans lequel le ou les fils conducteurs (5) sont enrobés dans un film plastique formant une nappe, le film plastique formant la nappe pouvant notamment être transparent ou noir ou de couleur, la nappe étant équipée de connecteurs à chacune de ses extrémités.

13. Vitrage selon la revendication 12, **caractérisé en ce que** l'autre extrémité (51) de chaque fil conducteur (5) sort du vitrage feuilleté par la tranche du vitrage feuilleté ou par un deuxième trou traversant (8) de la première feuille de verre (1) situé en bord de vitrage ou par un trou traversant de la deuxième feuille de verre (2) situé en bord de vitrage, chaque fil conducteur étant d'un seul tenant entre les deux sorties du vitrage feuilleté.

## Patentansprüche

1. Verfahren zum Herstellen einer Verbundverglasung, umfassend:
- eine erste und eine zweite Glasscheibe (1, 2), wobei die erste Glasscheibe (1) mit einem ersten Durchgangsloch (4) versehen ist,
- eine Zwischenlagefolie (3) aus thermoplastischem Polymer, die zwischen der ersten und der zweiten Glasscheibe (1, 2) angeordnet ist,
- mindestens einen leitenden Draht (5), der in die Zwischenlagefolie (3) eingelassen oder zwischen der Zwischenlagefolie (3) und der ersten Glasscheibe (1) angeordnet oder zwischen der Zwischenlagefolie und der zweiten Glasscheibe angeordnet ist, wobei ein Ende (50) jedes leitenden Drahts (5) aus der Verbundverglasung durch das erste Durchgangsloch (4) der ersten Glasscheibe (1) austritt,
das Verfahren umfassend:
- das Bereitstellen der ersten und der zweiten Glasscheibe (1, 2),
- das Schneiden eines ersten Durchgangslochs (4) in die erste Glasscheibe (1),
- falls notwendig, das Biegen der ersten und der zweiten Glasscheibe (1, 2),
- entweder
∘ das Bereitstellen des oder der leitenden Drähte (5) und der Folie (3) aus thermoplastischem Polymer, optional versehen mit einem Durchgangsloch, und das Befestigen des oder der leitenden Drähte (5) auf der Folie (3) aus thermoplastischem Polymer, das Einrichten der Folie (3) aus thermoplastischem Polymer, die den oder die leitenden Drähte (5) trägt, zwischen der ersten und der zweiten Glasscheibe (1, 2) und das Austreten eines Endes (50) des oder der leitenden Drähte (5) durch das erste Durchgangsloch (4), wobei das Ende (50) mit einem Verbinder vor dem Durchlaufen des ersten Durchgangslochs ausgestattet wird,
oder
∘ das Bereitstellen des oder der leitfähigen Drähte (5), die mit einer Kunststofffolie umhüllt sind, die ein Bündel ausbildet, und einer Folie (3) aus thermoplastischem Polymer, optional versehen mit einem Durchgangsloch, dann das Einrichten der Folie (3) aus thermoplastischem Polymer zwischen der ersten und der zweiten Glasscheibe (1, 2), wobei das Bündel aus leitenden Drähten zwischen der Folie (3) aus thermoplastischem Polymer und der ersten Glasscheibe (1) oder der zweiten Glasscheibe (2) angeordnet wird, und das Austreten eines Endes (50) des oder der leitenden Drähte (5) durch das Durchgangsloch (4), wobei das Bündel mit Verbindern an jedem seiner Enden vor dem Zusammenbauen der Verglasung ausgestattet wird,
- das Vakuumentgasen der Baugruppe unter Verwendung einer Umfangsdichtung oder eines Vakuumbeutels sowie eines Haftmittels zum Verschließen des oder der Durchgangslöcher der Glasscheibe(n) oder eines Saugers zum Absaugen von Luft durch das oder die Durchgangslöcher der Glasscheibe(n),
- das Heißversiegeln der Ränder der Verbundverglasung und der Ränder des oder der Durchgangslöcher,
- das Autoklavieren der Baugruppe.

2. Verfahren nach dem vorstehenden Anspruch,
**dadurch gekennzeichnet, dass,** wenn der leitende Draht (5) zwischen der Zwischenlagefolie (3) und der zweiten Glasscheibe (2) angeordnet ist, die Zwischenlagefolie (3) mit einem Durchgangsloch versehen ist, das das Durchlaufen des leitenden Drahts (5) durch die Zwischenlagefolie (3) und durch die erste Glasscheibe (1) ermöglicht, wobei das Durchgangsloch der Zwischenlagefolie eine Größe aufweist, die zwischen einem Minimalwert, der gerade das Durchlaufen des leitenden Drahts ermöglicht, und einem Maximalwert liegt, zu dem das Loch mit dem ersten Loch (4) der ersten Glasscheibe (1) im Wesentlichen übereinstimmt.

3. Verfahren nach einem der vorstehenden Ansprüche,
**dadurch gekennzeichnet, dass** die zweite Glasscheibe (2) ebenfalls mit einem Durchgangsloch (15) versehen ist, wobei das erste Durchgangsloch (4) der ersten Glasscheibe (1) und das Durchgangsloch (15) der zweiten Glasscheibe (2) im Wesentlichen die gleiche Größe aufweisen und einander zugewandt sind, wobei die Zwischenlagefolie (3) ebenfalls mit einem Durchgangsloch versehen ist, das mit den Durchgangslöchern (4, 15) der ersten und der zweiten Glasscheibe (1, 2) übereinstimmt.

4. Verfahren nach einem der vorstehenden Ansprüche,
**dadurch gekennzeichnet, dass** der oder die leitenden Drähte (5) mit einer Kunststofffolie umhüllt sind, die ein Bündel ausbildet, wobei die Kunststofffolie, die das Bündel ausbildet, transparent oder schwarz oder gefärbt ist.

5. Verfahren nach einem der vorstehenden Ansprüche,
**dadurch gekennzeichnet, dass** das andere Ende (51) jedes leitenden Drahts (5) durch die Schmalseite der Verbundverglasung oder durch ein zweites Durchgangsloch (8) der ersten Glasscheibe (1) austritt, das sich an dem Rand der Verglasung befindet, oder durch ein Durchgangsloch der zweiten Glasscheibe (2), das sich an dem Rand der Verglasung befindet, wobei jeder leitende Draht zwischen den zwei Ausgängen der Verbundverglasung aus einem Stück ist.

6. Verfahren nach einem der vorstehenden Ansprüche,
**dadurch gekennzeichnet, dass** die Verglasung mehrere leitende Drähte (5) umfasst, wobei ein Ende (50) jedes leitenden Drahts (5) aus der Verbundverglasung durch das oder die ersten Durchgangslöcher (4) der ersten Glasscheibe (1) austritt.

7. Verfahren nach einem der vorstehenden Ansprüche,
**dadurch gekennzeichnet, dass** jedes Durchgangsloch (4, 8, 15) eine Größe, die zwischen 3 und 80 mm liegt, aufweist.

8. Verfahren nach einem der vorstehenden Ansprüche,
**dadurch gekennzeichnet, dass** mindestens ein Streifen undurchsichtiger Emaille mit dem oder den leitenden Drähten (5) übereinstimmt, wobei der oder die leitenden Drähte vor der Sicht von außen und/oder von innen verborgen werden.

9. Verfahren nach einem der vorstehenden Ansprüche,
**dadurch gekennzeichnet, dass** der leitende Draht (5) ein vorzugsweise abgeschirmtes Koaxialkabel ist.

10. Verfahren nach einem der vorstehenden Ansprüche,
**dadurch gekennzeichnet, dass** ein Zubehörteil (6), insbesondere ein Regen- oder Feuchtigkeitssensor, ein Lichtsensor, eine Kamera, eine Antenne, eine Beleuchtungsvorrichtung, ein Ventilator oder auch eine GPS-Positionierungsvorrichtung auf der Verbundverglasung in der Nähe oder an dem oder den ersten Durchgangslöchern (4) befestigt wird, wobei das Zubehörteil mit dem Ende (50) des oder der leitenden Drähte (5) verbunden ist, die aus der Verbundverglasung durch das oder die ersten Durchgangslöcher (4) der ersten Glasscheibe (1) austreten.

11. Verfahren nach dem vorstehenden Anspruch,
**dadurch gekennzeichnet, dass** das Zubehörteil (6) an oder in der Nähe der Ränder des oder der ersten Durchgangslöcher (4) der ersten Glasscheibe (1) befestigt oder im Inneren eines Durchgangslochs (4) der ersten Glasscheibe (1) untergebracht und auf der zweiten Glasscheibe (2) befestigt ist.

12. Verbundverglasung, die dafür geeignet ist, an einem Kraftfahrzeug montiert zu werden, umfassend:
- eine erste und eine zweite Glasscheibe (1, 2), wobei die erste Glasscheibe (1) mit einem ersten Durchgangsloch (4) versehen ist,
- eine Zwischenlagefolie (3) aus thermoplastischem Polymer, die zwischen der ersten und der zweiten Glasscheibe (1, 2) angeordnet ist,
- mindestens einen leitenden Draht (5), der in der Zwischenlagefolie (3) eingelassen oder zwischen der Zwischenlagefolie (3) und der ersten Glasscheibe (1) angeordnet oder zwischen der Zwischenlagefolie und der zweiten Glasscheibe angeordnet ist, ein Ende (50) jedes leitenden Drahts (5), der aus der Verbundverglasung durch das erste Durchgangsloch (4) der ersten Glasscheibe (1) austritt,
und wobei der oder die leitenden Drähte (5) mit einer Kunststofffolie umhüllt sind, die ein Bündel ausbildet, wobei die Kunststofffolie, die das Bündel ausbildet, insbesondere transparent oder schwarz oder gefärbt sein kann, wobei das Bündel mit Verbindern an jedem seiner Enden ausgestattet ist.

13. Verglasung nach Anspruch 12, **dadurch gekennzeichnet, dass** das andere Ende (51) jedes leitenden Drahts (5) durch die Schmalseite der Verbundverglasung oder durch ein zweites Durchgangsloch (8) der ersten Glasscheibe (1) austritt, das sich an dem Rand der Verglasung befindet, oder durch ein Durchgangsloch der zweiten Glasscheibe (2), das sich an dem Rand der Verglasung befindet, wobei jeder leitende Draht zwischen den zwei Ausgängen der Verbundverglasung aus einem Stück ist.

## Claims

1. Method for producing a laminated glazing unit comprising:
- a first and a second glass sheet (1, 2), the first glass sheet (1) being provided with a first through-hole (4),
- a spacer film (3) made of thermoplastic polymer which is arranged between the first glass sheet and second glass sheet (1, 2),
- at least one conducting wire (5) embedded in the spacer film (3) or arranged between the spacer film (3) and the first glass sheet (1) or arranged between the spacer film and the second glass sheet, one end (50) of each conducting wire (5) exiting the laminated glazing unit through the first through-hole (4) of the first glass sheet (1),
said method comprising:
- providing the first glass sheet and the second glass sheet (1, 2),
- cutting a first through-hole (4) in the first glass sheet (1),
- if necessary, bending the first glass sheet and second glass sheet (1, 2),
- either
∘ providing the conducting wire(s) (5) and the thermoplastic polymer film (3) optionally provided with a through-hole, and attaching the conducting wire(s) (5) to the thermoplastic polymer film (3), placing the thermoplastic polymer film (3) carrying the conducting wire(s) (5) between the first glass sheet and second glass sheet (1, 2), and one end (50) of the conducting wire(s) (5) exiting through the first through-hole (4), said end (50) being fitted with a connector before passing through the first through-hole,
or
∘ providing the conducting wire(s) (5) which are coated with a plastic film forming a web, and a thermoplastic polymer film (3) optionally provided with a through-hole, then placing the thermoplastic polymer film (3) between the first glass sheet and second glass sheet (1, 2), the web of conducting wires being arranged between the thermoplastic polymer film (3) and the first glass sheet (1) or the second glass sheet (2), and one end (50) of the conducting wire(s) (5) exiting through the first through-hole (4), the web being equipped with connectors at each of the ends thereof before assembly of the glazing unit,
- vacuum degassing of the assembly, using a peripheral seal or a vacuum bag and an adhesive to block the through-hole(s) of the glass sheet(s), or a suction device to draw air through the through-hole(s) of the glass sheet(s),
- heat sealing the edges of the laminated glazing unit and the edges of the through-hole(s),
- autoclaving of the assembly.

2. Method according to the preceding claim, **characterized in that** when the conducting wire (5) is arranged between the spacer film (3) and the second glass sheet (2) the spacer film (3) is provided with a through-hole allowing the conducting wire (5) to pass through the spacer film (3) and through the first glass sheet (1), the through-hole of the spacer film having a size between a minimum value just allowing the passage of the conducting wire and a maximum value at which the hole substantially coincides with the first hole (4) of the first glass sheet (1).

3. Method according to one of the preceding claims, **characterized in that** the second glass sheet (2) is also provided with a through-hole (15), the first through-hole (4) of the first glass sheet (1) and the through-hole (15) of the second glass sheet (2) having substantially the same size and facing each other, the spacer film (3) also being provided with a through-hole coinciding with the through-holes (4, 15) of the first glass sheet and second glass sheet (1, 2).

4. Method according to one of the preceding claims, **characterized in that** the conducting wire(s) (5) are coated with a plastic film forming a web, the plastic film forming the web being transparent or black or colored.

5. Method according to one of the preceding claims, **characterized in that** the other end (51) of each conducting wire (5) exits the laminated glazing unit through the edge face of the laminated glazing unit or through a second through-hole (8) of the first glass sheet (1) located at the edge of the glazing unit or through a through-hole of the second glass sheet (2) located at the edge of the glazing unit, each conducting wire being made of a single piece between the two outlets of the laminated glazing unit.

6. Method according to one of the preceding claims, **characterized in that** the glazing unit comprises several conducting wires (5), an end (50) of each conducting wire (5) exiting the laminated glazing unit through the first through-hole(s) (4) of the first glass sheet (1).

7. Method according to one of the preceding claims, **characterized in that** each through-hole (4, 8, 15) has a size of between 3 and 80 mm.

8. Method according to one of the preceding claims, **characterized in that** at least one opaque enamel strip coincides with the conducting wire(s) (5), concealing the conducting wire(s) from view from the outside and/or inside.

9. Method according to one of the preceding claims, **characterized in that** the conducting wire (5) is a coaxial cable, preferably shielded.

10. Method according to one of the preceding claims, **characterized in that** an accessory (6), in particular a rain or humidity sensor, a brightness sensor, a camera, an antenna, a lighting device, a fan or a GPS positioning device, is attached to the laminated glazing unit near or at the level of the first through-hole(s) (4), the accessory being connected to the end (50) of the conducting wire(s) (5) exiting the laminated glazing unit through the first through-hole(s) (4) of the first glass sheet (1).

11. Method according to the preceding claim, **characterized in that** the accessory (6) is attached on or near the edges of the first through-hole(s) (4) of the first glass sheet (1) or housed inside a through-hole (4) of the first glass sheet (1) and attached to the second glass sheet (2).

12. Laminated glazing unit for mounting on a motor vehicle, comprising:
- a first glass sheet and a second glass sheet (1, 2), the first glass sheet (1) being provided with a first through-hole (4),
- a spacer film (3) made of thermoplastic polymer which is arranged between the first glass sheet and second glass sheet (1, 2),
- at least one conducting wire (5) embedded in the spacer film (3) or arranged between the spacer film (3) and the first glass sheet (1) or arranged between the spacer film and the second glass sheet, one end (50) of each conducting wire (5) exiting the laminated glazing unit through the first through-hole (4) of the first glass sheet (1),
and in which the conducting wire(s) (5) are coated with a plastic film forming a web, the plastic film forming the web can be, in particular, transparent or black or colored, the web being equipped with connectors at each of the ends thereof.

13. Glazing unit according to claim 12, **characterized in that** the other end (51) of each conducting wire (5) exits the laminated glazing unit through the edge face of the laminated glazing unit or through a second through-hole (8) of the first glass sheet (1) located at the edge of the glazing unit or through a through-hole in the second glass sheet (2) located at the edge of the glazing unit, each conducting wire being made of a single piece between the two outlets of the laminated glazing unit.
